(19) Europäisches Patentamt
European Patent Office
Office européen des brevets

(11) EP 0 450 189 B1

(12) # EUROPÄISCHE PATENTSCHRIFT

(45) Veröffentlichungstag und Bekanntmachung des Hinweises auf die Patenterteilung:
**30.10.1996 Patentblatt 1996/44**

(51) Int Cl.[6]: **G03F 7/038**, G03F 7/012

(21) Anmeldenummer: **90125286.6**

(22) Anmeldetag: **21.12.1990**

(54) **Hochwärmebeständige Negativresists und Verfahren zur Herstellung hochwärmebeständiger Reliefstrukturen**

High temperature stable negative resists and process for the production of high temperature stable relief structure

Réserve négative stable à haute température et procédé d'obtention de structures en relief stables à la chaleur

(84) Benannte Vertragsstaaten:
**BE DE FR GB NL**

(30) Priorität: **29.03.1990 DE 4010125**

(43) Veröffentlichungstag der Anmeldung:
**09.10.1991 Patentblatt 1991/41**

(73) Patentinhaber: **SIEMENS AKTIENGESELLSCHAFT
80333 München (DE)**

(72) Erfinder:
- **Hammerschmidt, Albert, Dr.
W-8520 Erlangen (DE)**
- **Schmidt, Erwin
W-8520 Erlangen (DE)**
- **Kühn, Eberhard
S-8551 Hemhofen (DE)**

(56) Entgegenhaltungen:
**EP-A- 0 065 352**
**DE-A- 3 716 629**
**FR-A- 2 628 112**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft hochwärmebeständige Negativresists auf der Basis Von oligomeren und/oder polymeren Polybenzoxazol-Vorstufen sowie ein verfahren zur Herstellung hochwärmebeständiger Reliefstrukturen aus derartigen Negativresists.

In hochtemperaturbeständigen Photoresists, die für eine kostengünstige direkte Strukturierung organischer Isolierschichten benötigt werden, dienen Hydroxypolyamide als lösliche Polybenzoxazol-Vorstufen. Die aus den Hydroxypolyamiden erhaltenen Polybenzoxazole zeichnen sich durch eine hohe Temperaturbeständigkeit und eine geringe Wasseraufnahme sowie durch hervorragende elektrische Eigenschaften aus. Die Polybenzoxazole können als Ätzmasken, vor allem bei alkalischen Ätzprozessen, und auch als organische Dielektrika in der Halbleiterfertigung dienen.

Photostrukturierbare Polybenzoxazol-Vorstufen können sowohl in Positiv- als auch in Negativresists Verwendung finden. Die Positivresists enthalten dabei neben der Polymer-Vorstufe eine photoaktive Komponente in Form von Diazochinon (siehe dazu: EP-PS 0 023 662, EP-0S 0 291 779 und DE-0S 37 16 629), während die Negativresists Polymer-Vorstufen mit vernetzbaren ungesättigten Gruppen aufweisen (siehe dazu: EP-PS 0 041 677).

Bei beiden der genannten Resisttypen können allerdings Probleme bei der Lagerstabilität auftreten. Bei Hydroxypolyamide enthaltenden Positivresists kann in konzentrierten Resistlösungen eine Polykondensation erfolgen; Negativresists neigen infolge der Anwesenheit von ungesättigten Gruppen, wie Acryl- und Methacrylgruppen, zur Polymerisation. Bei beiden Resisttypen führt dies zu einer Viskositätserhöhung, bis hin zur Gelbildung. Bei Positivresists kann darüber hinaus die photoaktive Komponente durch basische Aminoendgruppen bzw. durch Aminmonomere und Amidoligomere zerstört werden.

Aufgabe der Erfindung ist es, kostengünstige hochwärmebeständige Negativresists auf der Basis von oligomeren und/oder polymeren Polybenzoxazol-Vorstufen anzugeben, bei denen die bislang mit derartigen Resists verbundenen Schwierigkeiten hinsichtlich der Lagerstabilität nicht auftreten.

Dies wird erfindungsgemäß dadurch erreicht, daß die Resists eine photoaktive Komponente in Form eines Bisazids enthalten, und daß die Polybenzoxazol-Vorstufen Hydroxypolyamide folgender Struktur sind:

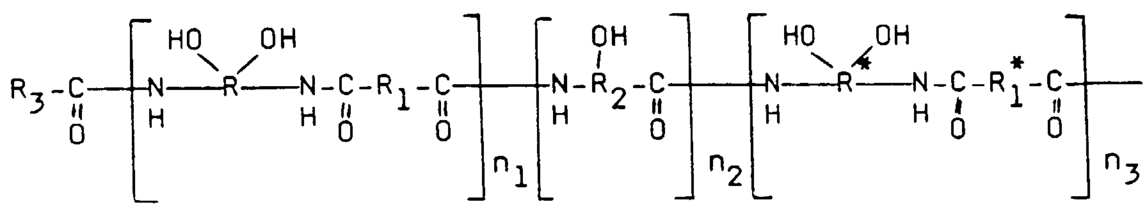

,

wobei R, R*, $R_1$, $R_1^*$ und $R_2$ aromatische Gruppen sind, $R_3$ eine aromatische Gruppe oder ein Norbornenrest ist, und bezüglich $n_1$, $n_2$ und $n_3$ folgendes gilt:

$n_1 = 1$ bis 100, $n_2$ und $n_3 = 0$ oder
$n_1$ und $n_2 = 1$ bis 100, $n_3 = 0$ oder
$n_2 = 1$ bis 100, $n_1$ und $n_3 = 0$ oder
$n_1$, $n_2$ und $n_3 = 1$ bis 100 (mit $R \neq R^*$ und/oder $R_1 \neq R_1^*$) oder
$n_1$ und $n_3 = 1$ bis 100, $n_2 = 0$ (mit $R \neq R^*$ und/oder $R_1 \neq R_1^*$), mit der Maßgabe: $n_1 + n_2 + n_3 \geq 3$.

Aus Hydroxypolyamiden der vorstehend genannten Art lassen sich - in Gegenwart eines Bisazids - auf photolithographischem Weg überraschenderweise Reliefstrukturen erzeugen, welche bei und nach dem Tempern eine hohe Wärmeformbeständigkeit aufweisen.

Die Polybenzoxazol-Vorstufen selbst zeigen in Lösung eine hervorragende Lagerstabilität, und zwar sowohl hinsichtlich der Viskosität der Lösung als auch hinsichtlich der Stabilität der photoaktiven Komponente. Die erfindungsgemäßen Photoresists besitzen darüber hinaus einen sehr geringen Dunkelabtrag beim Entwickeln; der Schichtdikkenverlust beim Tempern entspricht mit 35 % demjenigen der reinen Polybenzoxazol-Vorstufen und stellt den für dieses System optimal erreichbaren Wert dar.

Im Gegensatz zu den bekannten Negativresists auf Polybenzoxazol-Basis weisen die erfindungsgemäßen Resists keine Hydroxypolyamide mit ungesättigten Gruppen auf; diese Resists enthalten vielmehr eine photoaktive Komponente in Form eines Bisazids. Die Verwendung von bisazidgruppenhaltigen photoaktiven Komponenten in Negativresists ist zwar bereits bekannt, sie finden bislang allerdings lediglich bei natürlichem und synthetischem Kautschuk Verwendung (siehe dazu: US-PS 2 852 379 und US-PS 2 940 853). Für Kautschuke sowie für andere Polymere, wie Polystyrol, Polyamid, Novolakharze, Poly(vinylphenol) und Poly(vinylbutyral), ist auch die Verwendung sulfongruppenhaltiger Bisazide bekannt (siehe dazu: DE-PS 29 48 324 sowie "IEEE Trans. Electron Devices", Vol. ED-28 (1981), Seiten 1306 bis 1310). Im Gegensatz dazu gelangen in den erfindungsgemäßen Resists Polybenzoxazol-Vorstufen in Form von Hydroxypolyamiden zum Einsatz, und zwar in Form von speziellen Hydroxypolyamiden. Bei diesen Hydroxypolyamiden sind nämlich die üblicherweise vorhandenen Aminoendgruppen in ganz bestimmter Weise modifiziert.

Für die Hydroxypolyamide der vorstehend genannten Art gilt im allgemeinen folgendes.

R und $R^*$ können folgende Bedeutung haben:

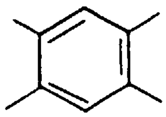 , 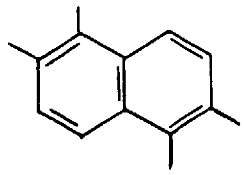 , 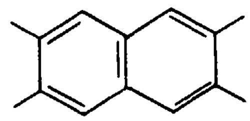 ,

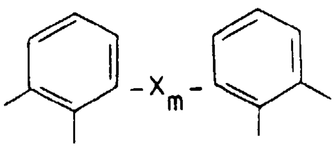 , 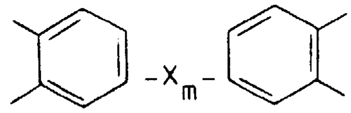 ,

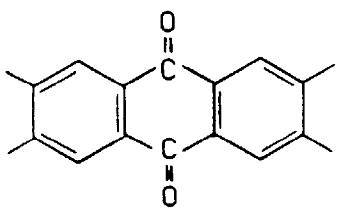 , 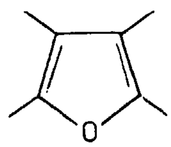 , 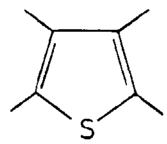

und

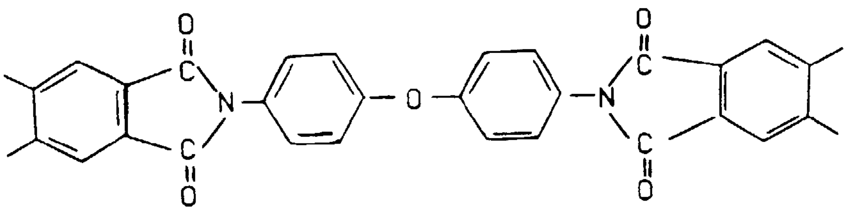 .

$R_1$ und $R_1^*$ können folgende Bedeutung haben, wobei H-Atome auch durch Cl oder Br substituiert sein können:

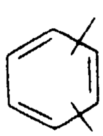 , 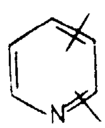 , 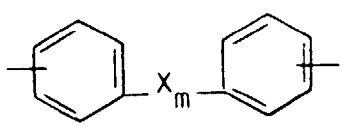 und 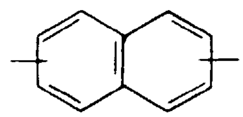 .

$R_2$ kann folgende Bedeutung haben:

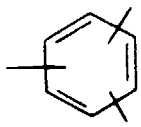, 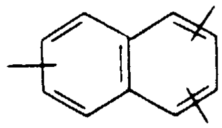 und 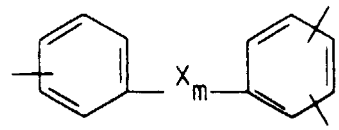 ;

die aromatischen Reste können dabei auch Alkylsubstituenten tragen.

$R_3$ kann folgende Bedeutung haben:

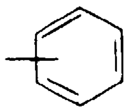, 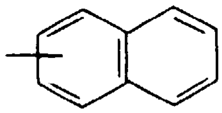, 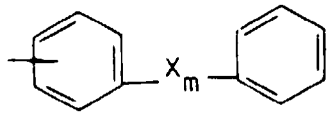 und 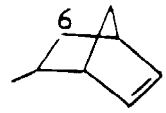 ;

die aromatischen Reste können dabei auch Halogen- oder Alkylsubstituenten tragen, ferner kann an den aromatischen Resten - in o-Stellung zur Bindung zur Säureamidgruppierung (-CO-NH-) - eine COOH-Gruppe angeordnet sein; eine entsprechende Gruppe kann in der 6-Stellung des Norbornenrestes angeordnet sein.

Für m und X gilt dabei folgendes:

m = 0 oder 1, und

X bedeutet:

-O-, >CO, 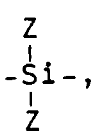, 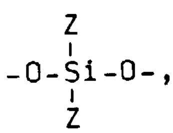, -S-, $-SO_2-$, 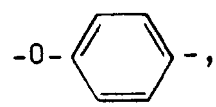, 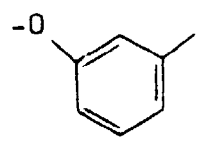,

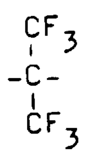, 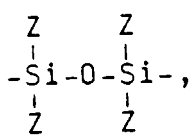, 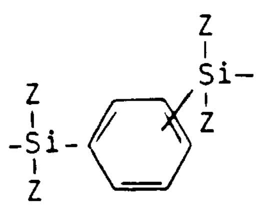, 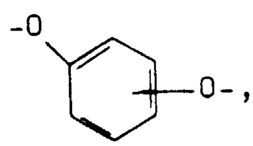, 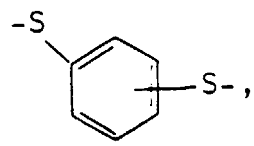,

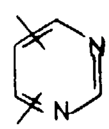

und

$-(CF_2)_r-$ ;

dabei gilt folgendes:

Z = Alkyl mit 1 bis 10 Kohlenstoffatomen oder Aryl, und

r = 2 bis 18.

Für die Hydroxypolyamide dienen als Basismaterialien Polykondensationsprodukte, und zwar

- Co-Polykondensationsprodukte aus aromatischen Diaminodihydroxyverbindungen und aromatischen Dicarbonsäuren bzw. Dicarbonsäurechloriden;
- Homo-Polykondensationsprodukte aromatischer Aminohydroxycarbonsäuren;
- Co-Polykondensationsprodukte aus aromatischen Diaminodihydroxyverbindungen, aromatischen Dicarbonsäuren bzw. Dicarbonsäurechloriden und aromatischen Aminohydroxycarbonsäuren.

Vorzugsweise werden Hydroxypolyamide folgender Art eingesetzt:

- Polykondensationsprodukte aus 3.3'-Dihydroxybenzidin und Isophthalsäuredichlorid;
- Polykondensationsprodukte aus 3.3'-Dihydroxybenzidin, 2.2-Bis(3-amino-4-hydroxyphenyl)-1.1.1.3.3.3-hexafluorpropan und Isophthalsäuredichlorid;
- Polykondensationsprodukte von 3-Amino-4-hydroxybenzoesäure.

Als Diaminodihydroxyverbindungen können - neben 3.3'-Dihydroxybenzidin (3.3'-Dihydroxy-4.4'-diaminobiphenyl) - auch Isomere dieser Verbindung eingesetzt werden und auch andere hydroxylgruppenhaltige aromatische Diamine, wie 3.3'-Dihydroxy-4.4'-diaminodiphenylether. Neben Isophthalsäuredichlorid kann - als Dicarbonsäure - auch Isophthalsäure verwendet werden. Als Dicarbonsäure kann aber auch Terephthalsäure und als Dicarbonsäurederivat Terephthalsäuredichlorid dienen.

Die Basismaterialien weisen Aminoendgruppen auf, die noch modifiziert werden, und zwar in der Weise, daß die Aminogruppen in Säureamidgruppen (von aromatischen Carbonsäuren bzw. Norbornencarbonsäure) übergeführt werden. Die Modifizierung erfolgt dabei in der Weise, daß die Aminoendgruppen mit geeigneten Carbonsäurederivaten, insbesondere Carbonsäurechloriden und Dicarbonsäureanhydriden, zur Reaktion gebracht werden.

Als photoaktive Komponente gelangen in den erfindungsgemäßen Negativresists insbesondere aromatische Bisazide zum Einsatz, vorzugsweise 2.6-Bis(4'-azidobenzal)-cyclohexanon oder 2.6-Bis(4'-azidobenzal)-4-methylcyclohexanon. Daneben können aber auch ancere Verbindungen wie 4.4'-Diazidobenzophenon und 4.4'-Diazidodiphenylmethan eingesetzt werden. Das Masseverhältnis von Hydroxypolyamid zu Bisazid beträgt dabei vorteilhaft 1:20 bis 20:1, vorzugweise 1:10 bis 10:1.

Zur Herstellung hochwärmebeständiger Reliefstrukturen wird ein erfindungsgemäßer Negativresist in Form einer Schicht oder Folie auf ein Substrat aufgebracht und mit aktinischem Licht durch eine Maske belichtet oder durch Führen eines Licht-, Elektronen- oder Ionenstrahls bestrahlt. Anschließend werden die unbelichteten bzw. unbestrahlten Schicht- oder Folienteile herausgelöst oder abgezogen, und die dabei erhaltenen Reliefstrukturen werden dann getempert.

Der Photoresist kann vorteilhaft in einem organischen Lösungsmittel gelöst auf das Substrat aufgebracht werden. Als Lösungsmittel wird dabei vorzugsweise N-Methylpyrrolidon verwendet. Daneben können aber auch andere organische Lösungsmittel mit ähnlichen Eigenschaften zum Einsatz gelangen, wie Dimethylformamid und N.N-Dimethylacetamid, sowie Gemische der genannten Lösungsmittel.

Bei der Herstellung der Reliefstrukturen kann vorteilhaft ein Haftvermittler und/oder ein Benetzungsmittel verwendet werden. Haftvermittler bzw. Benetzungsmittel können dabei der Polymerlösung zugesetzt werden, sie können aber auch - vor der Beschichtung - auf das Substrat aufgebracht werden. Die Polymerlösung wird vorzugsweise mittels Schleudertechnik sowie Tauchoder Sprühverfahren auf das Substrat aufgebracht. Daneben können aber auch andere Beschichtungsmethoden, wie Bürsten und Rollen, angewendet werden. Das Substrat besteht vorzugsweise aus Glas, aus Metall, insbesondere Aluminium, aus Kunststoff oder aus einem halbleitenden Material.

Die Umwandlung der strukturierten Polymerschichten in hochwärmebeständige Polybenzoxazole erfolgt durch einen Temperprozeß. Im allgemeinen werden dabei Temperaturen zwischen 200 und 500°C gewählt. Vorzugsweise erfolgt die Temperung bei einer Temperatur zwischen 300 und 450°C.

Anhand von Ausführungsbeispielen soll die Erfindung noch näher erläutert werden.

1. Herstellung eines Hydroxypolyamids

105 Masseteile 2.2-Bis(3-amino-4-hydroxyphenyl)1.1.1.3.3.3-hexafluorpropan und 62 Masseteile 3.3'-Dihydroxybenzidin werden unter Argon in 1380 Masseteilen N.N-Dimethylacetamid und 250 Masseteilen Pyridin gelöst. Zu der auf 0°C abgekühlten Lösung werden dann unter starkem Rühren 104 Masseteile Isophthalsäuredichlorid, gelöst in 460 Masseteilen Cyclohexanon, zugetropft. Nach 2 1/2stündigem Rühren läßt man die Reaktionsmischung auf Raumtemperatur erwärmen und rührt weitere 3 1/2 h. Nach 12stündigem Stehen werden unter Rühren langsam 32,2 Masseteile Benzoylchlorid zugetropft, dann läßt man für 12 h bei Raumtemperatur stehen. Anschließend wird die Reaktionslösung in 18 1 Wasser getropft, das dabei ausfallende Polymere wird dann gewaschen und im Vakuumtrockenschrank über NaOH getrocknet.

2. Reinigung des Hydroxypolyamids

Das nach Beispiel 1 hergestellte Hydroxypolyamid wird mittels Ionenaustauschern gereinigt. Dazu werden 150 Masseteile eines handelsüblichen Anionenaustauschers in destilliertem Wasser aufgeschlämmt, in eine Chromatographiesäule gefüllt und neutral gewaschen; anschließend wird das Wasser durch N-Methylpyrrolidon ersetzt. In entsprechender Weise werden 100 Masseteile eines handelsüblichen Kationenaustauschers in destilliertem Wasser aufgeschlämmt, in eine Chromatographiesäule gefüllt und solange mit 10 %iger HCl gewaschen, bis das Eluat sauer reagiert; anschließend wird mit Wasser neutral und chloridfrei gewaschen und das Wasser dann durch N-Methylpyrrolidon ersetzt.

Zur Reinigung werden 200 Masseteile getrocknetes Hydroxypolyamid in 2000 Masseteilen N-Methylpyrrolidon gelöst, und die Lösung wird dann auf den Anionen- und den Kationenaustauscher gegeben. Die auf diese Weise gereinigte Polymerlösung wird zu ca. 17 1 Wasser getropft, das dabei ausfallende Polymere isoliert, gewaschen und im Vakuumtrockenschrank über NaOH getrocknet.

In der vorstehend beschriebenen Weise hergestellte Lösungen von Polybenzoxazol-Vorstufen in Form endgruppenmodifizierter Hydroxypolyamide zeichnen sich gegenüber Lösungen entsprechender nicht-endgruppenmodifizierter Hydroxypolyamide durch eine besonders gute Viskositätsstabilität aus. Während nämlich 33 %ige Lösungen der erstgenannten Art bei einer Lagertemperatur von 40°C annähernd 150 h stabil sind, erfolgt bei Lösungen der zweiten Art bereits nach ca. 15 h eine Viskositätserhöhung.

3. Herstellung einer Resistlösung

15 Masseteile einer in der vorstehend beschriebenen Weise hergestellten und gereinigten Polybenzoxazol-Vorstufe werden zu einer Lösung von 3 Masseteilen 2.6-Bis(4'-azidobenzal)-4-methylcyclohexanon in 51 Masseteilen N-Methylpyrrolidon gegeben; die dabei erhaltene Lösung wird dann durch ein 0,8 µm-Filter druckfiltriert.

Eine derartige Lösung erweist sich als lagerstabil und zwar sowohl hinsichtlich der Viskosität der Lösung als auch hinsichtlich der technologischen Eigenschaften. So erfolgt bei einer Lagertemperatur von 40°C innerhalb von 160 h keine Viskositätserhöhung, und die technologischen Eigenschaften sind bei einer Lagertemperatur von -18°C noch nach 20 Tagen unverändert.

4. Herstellung einer Reliefstruktur

Auf eine Siliciumscheibe wird zunächst ein Haftvermittler aufgebracht (5000 Umdrehungen/min - 30 s; 80°C - 10 min). Dann wird die Siliciumscheibe mittels eines Schleuderverfahrens (1200 Umdrehungen/min - 20 s) mit einer entsprechend Beispiel 3 hergestellten photoreaktiven Lösung beschichtet (Schichtdicke: 2,7 µm). Anschließend wird 30 s durch eine Maske belichtet (MJP 55: 42 $mW/cm^2$, gemessen mit OAI 400 nm), mit einem MIF-Entwickler NMD-3 (0,32 %ig) entwickelt und dann im Diffusionsofen unter Stickstoff getempert (Temperprogramm: Raumtemperatur bis 170°C: 1 h, 170 bis 300°C: 1 h, 300 bis 400°C: 1 h, 400°C: 1 h, 400°C bis Raumtemperatur: 4 h).

Dabei entstehen feine wärmeformbeständige Reliefstrukturen. Der Schichtdickenverlust (Dunkelabtrag) ist sehr gering: Der gesamte Schichtdickenverlust beträgt lediglich 35 %.

**Patentansprüche**

1. Hochwärmebeständige Negativresists auf der Basis von oligomeren und/oder polymeren Polybenzoxazol-Vorstufen, **dadurch gekennzeichnet,** daß sie eine photoaktive Komponente in Form eines Bisazids enthalten, und daß die Polybenzoxazol-Vorstufen Hydroxypolyamide folgender Struktur sind:

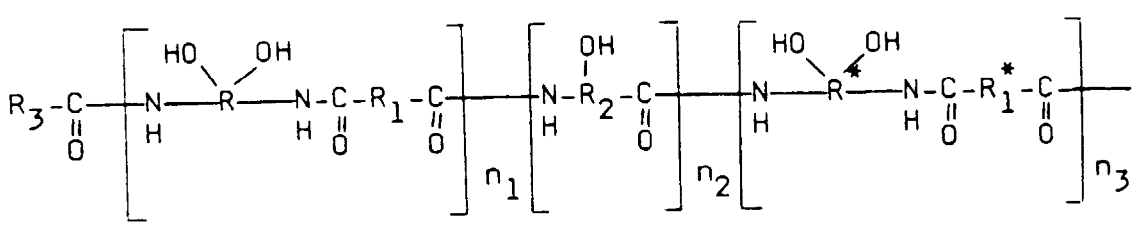 ,

wobei R, R*, $R_1$, $R_1^*$ und $R_2$ aromatische Gruppen sind, $R_3$ eine aromatische Gruppe oder ein Norbornenrest ist, und bezüglich $n_1$, $n_2$ und $n_3$ folgendes gilt:

$n_1 = 1$ bis 100, $n_2$ und $n_3 = 0$ oder
$n_1$ und $n_2 = 1$ bis 100, $n_3 = 0$ oder
$n_2 = 1$ bis 100, $n_1$ und $n_3 = 0$ oder
$n_1$, $n_2$ und $n_3 = 1$ bis 100 (mit $R \neq R^*$ und/oder $R_1 \neq R_1^*$) oder
$n_1$ und $n_3 = 1$ bis 100, $n_2 = 0$ (mit $R \neq R^*$ und/oder $R_1 \neq R_1^*$), mit der Maßgabe: $n_1 + n_2 + n_3 \geq 3$.

**2.** Negativresists nach Anspruch 1, **dadurch gekennzeichnet,** daß die photoaktive Komponente ein aromatisches Bisazid ist.

**3.** Negativresists nach Anspruch 2, **dadurch gekennzeichnet,** daß die photoaktive Komponente 2.6-Bis(4'-azidobenzal)-cyclohexanon oder 2.6-Bis(4'-azidobenzal)-4-methylcyclohexanon ist.

**4.** Negativresists nach einem der Ansprüche 1 bis 3, **dadurch gekennzeichnet,** daß das Masseverhältnis von Hydroxypolyamid zu Bisazid 1:20 bis 20:1, vorzugsweise 1:10 bis 10:1, beträgt.

**5.** Verfahren zur Herstellung hochwärmebeständiger Reliefstrukturen, **dadurch gekennzeichnet,** daß ein Negativresist nach einem oder mehreren der Ansprüche 1 bis 4 in Form einer Schicht oder Folie auf ein Substrat aufgebracht und mit aktinischem Licht durch eine Maske belichtet oder durch Führen eines Licht-, Elektronen- oder Ionenstrahls bestrahlt wird, daß die unbelichteten bzw. unbestrahlten Schicht- oder Folienteile herausgelöst oder abgezogen und die dabei erhaltenen Reliefstrukturen getempert werden.

**6.** Verfahren nach Anspruch 5, **dadurch gekennzeichnet,** daß der Negativresist in einem organischen Lösungsmittel gelöst auf das Substrat aufgebracht wird.

**7.** Verfahren nach Anspruch 6, **dadurch gekennzeichnet,** daß als Lösungsmittel N-Methylpyrrolidon verwendet wird.

**8.** Verfahren nach Anspruch 6 oder 7, **dadurch gekennzeichnet,** daß die Lösung mittels Schleudertechnik auf das Substrat aufgebracht wird.

**9.** Verfahren nach einem der Ansprüche 5 bis 8, **dadurch gekennzeichnet,** daß ein Haftvermittler und/oder ein Benetzungsmittel verwendet wird.

**10.** Verfahren nach einem oder mehreren der Ansprüche 5 bis 9, **dadurch gekennzeichnet,** daß bei einer Temperatur zwischen 200 und 500°C, vorzugsweise zwischen 300 und 450°C, getempert wird.

## Claims

**1.** Heat-resistant negative resists based on oligomeric and/or polymeric polybenzoxazole precursors, characterized in that they contain a photoactive component in the form of a bisazide, and in that the polybenzoxazole precursors are hydroxypolyamides of the following structure:

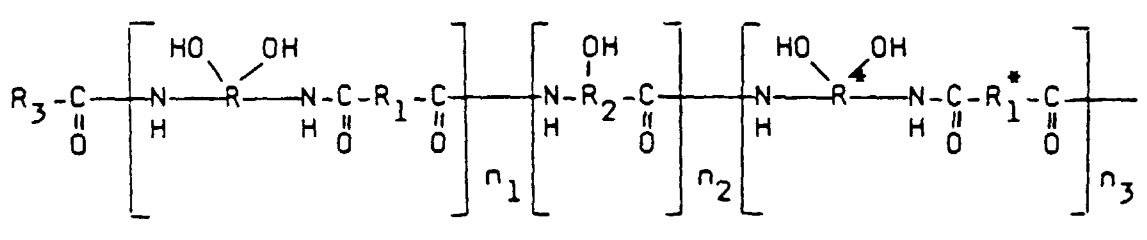

,

whereby R, R*, $R_1$, $R_1^*$ and $R_2$ are aromatic groups, $R_3$ is an aromatic group or a norbornene residue, and with respect to $n_1$, $n_2$ and $n_3$ the following applies:

$n_1 = 1$ to 100, $n_2$ and $n_3 = 0$ or
$n_1$ and $n_2 = 1$ to 100, $n_3 = 0$ or
$n_2 = 1$ to 100, $n_1$ and $n_3 = 0$ or
$n_1$, $n_2$ and $n_3 = 1$ to 100 (with $R \neq R^*$ and/or $R_1 \neq R_1^*$) or

$n_1$ and $n_3$ = 1 to 100, $n_2$ = 0 (with $R \neq R^*$ and/or $R_1 \neq R_1^*$),

with the condition that: $n_1 + n_2 + n_3 \geq 3$.

2. Negative resists according to claim 1, characterized in that the photoactive component is an aromatic bisazide.

3. Negative resists according to claim 2, characterized in that the photoactive component is 2,6-bis(4'-azidobenzale)-cyclohexanone or 2,6-bis(4'-azidobenzale)-4-methylcyclohexanone.

4. Negative resists according to one of claims 1 to 3, characterized in that the mass ratio of hydroxypolyamide to bisazide amounts to 1:20 to 20:1, preferably 1:10 to 10:1.

5. Method for producing heat-resistant relief structures, characterized in that a negative resist according to one or more of claims 1 to 4 is applied in the form of a layer or film to a substrate and is exposed with actinic light through a mask or is irradiated by directing a light beam, electron beam or ion beam, in that the unexposed or non-irradiated layer or film parts are dissolved out or removed and the relief structures thereby obtained are tempered.

6. Method according to claim 5, characterized in that the negative resist is applied to the substrate, dissolved in an organic solvent.

7. Method according to claim 6, characterized in that N-methylpyrrolidone is used as solvent.

8. Method according to claim 6 or 7, characterized in that the solution is applied to the substrate by means of a centrifugal technique.

9. Method according to one of claims 5 to 8, characterized in that an adhesive agent and/or a wetting agent is used.

10. Method according to one or more of claims 5 to 9, characterized in that tempering takes place at a temperature between 200 and 500°C, preferably between 300 and 450°C.

**Revendications**

1. Réserves négatives stables à haute température, à base de précurseurs de polybenzoxazole oligomères et/ou polymères, caractérisées en ce qu'elles contiennent un composant photoactif sous forme d'un bisazide, et en ce que les précurseurs de polybenzoxazole sont des hydroxypolyamides de structure ci-après:

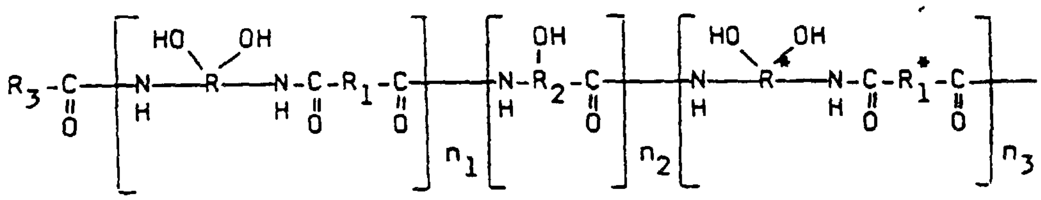

,

dans laquelle R, R*, $R_1$, $R_1^*$ et $R_2$ représentent des groupes aromatiques, $R_3$ représente un groupe aromatique ou un radical norbomène,
et, en ce qui concerne $n_1$, $n_2$ et $n_3$, est valable ce qui suit:

$n_1$ = 1 à 100, $n_2$ et $n_3$ = 0 ou
$n_1$ et $n_2$ = 1 à 100, $n_3$ = 0 ou
$n_2$ = 1 à 100, $n_1$ et $n_3$ = 0 ou
$n_1$, $n_2$ et $n_3$ = 1 à 100 (avec $R \neq R^*$ et/ou $R_1 \neq R_1^*$) ou encore $n_1$ et $n_3$ = 1 à 100, $n_2$ = 0 (avec $R \neq R^*$ et/ou $R_1 \neq R_1^*$) avec la mesure que: $n_1 + n_2 + n_3 \geq 3$

2. Réserves négatives selon la revendication 1, caractérisées en ce que le composant photoactif est un bisazide aromatique.

**3.** Réserves négatives selon la revendication 2, caractérisées en ce que le composant photoactif est la 2,6-bis(4'-azidobenzal)-cyclohexanone ou la 2,6-bis(4'-azido-benzal)-4-méthylcyclohexanone.

**4.** Réserves négatives selon l'une quelconque des revendications 1 à 3, caractérisées en ce que le rapport de masse de l'hydroxypolyamide au bisazide s'élève de 1:20 à 20:1, de préférence de 1:10 à 10:1.

**5.** Procédé pour la fabrication de structures en relief stables à haute température, caractérisé en ce qu'on applique une réserve négative selon l'une ou plusieurs des revendications 1 à 4, sous forme d'une couche ou d'une feuille sur un substrat et on l'expose à la lumière actinique à travers un masque ou bien on l'expose à un rayonnement en guidant un faisceau lumineux, électronique ou ionique, en ce qu'on élimine par dissolution ou par pelliculage les parties de couche ou de feuille non exposées à la lumière, respectivement non exposées au rayonnement, et on soumet à un traitement thermique les structures en relief obtenues en l'occurrence.

**6.** Procédé selon la revendication 5, caractérisé en ce que la réserve négative est appliquée sur le substrat à l'état dissous dans un solvant organique.

**7.** Procédé selon la revendication 6, caractérisé en ce que, comme solvant, on utilise la N-méthylpyrrolidone.

**8.** Procédé selon la revendication 6 ou 7, caractérisé en ce qu'on applique la solution sur le substrat au moyen d'une technique de centrifugation.

**9.** Procédé selon l'une quelconque des revendications 5 à 8, caractérisé en ce qu'on utilise un adhésif et/ou un agent mouillant.

**10.** Procédé selon une ou plusieurs des revendications 5 à 9, caractérisé en ce qu'on procède à un traitement thermique à une température entre 200 et 500°C, de préférence entre 300 et 450°C.